# EUROPEAN PATENT APPLICATION

(11) **EP 0 599 506 A1**
(43) Date of publication of application: **01.06.1994**
(21) Application number: 93308797.5
(22) Date of filing: 03.11.1993
(51) Int. Cl.: H01L 27/108

(54) **Semiconductor memory cell with SOI MOSFET**

(30) Priority: 27.11.1992 JP 318056/92
(71) Applicant: International Business Machines Corporation, Armonk, N.Y. 10504 (US)
(72) Inventor: Igarashi, Ryo, Moriyama-shi, Shiga-ken (JP)
(74) Representative: Burt, Roger James, Dr.

(57) **Abstract**

A dynamic semiconductor memory cell 72 includes a trench 81 having an insulating film 74 that is used as a dielectric material of a memory capacitor, and a MOSFET 80 that is formed by a process including a step of transforming a polysilicon film 85 on the insulating film 74 into a single crystal. The adjacent trenches are insulated by the insulating film 74 and the MOSFET of the Semiconductor-on-Insulator structure is used to provide a structure which can prevent a leak current, does not need highly accurate mask positioning, and can provide a higher degree of integration. The SOI MOSFET is deposited on the same insulating film 74 that is used as a dielectric material in the capacitor. By keeping the surface of the insulating film 74 over the substrate 71 flush with that of the storage electrode layer 73 the SOI MOSFET can be formed without a contact opening step for the source 76.

## Description

The present invention relates to a semiconductor memory cell, such as used in dynamic random access memory devices, and a manufacturing method therefor.

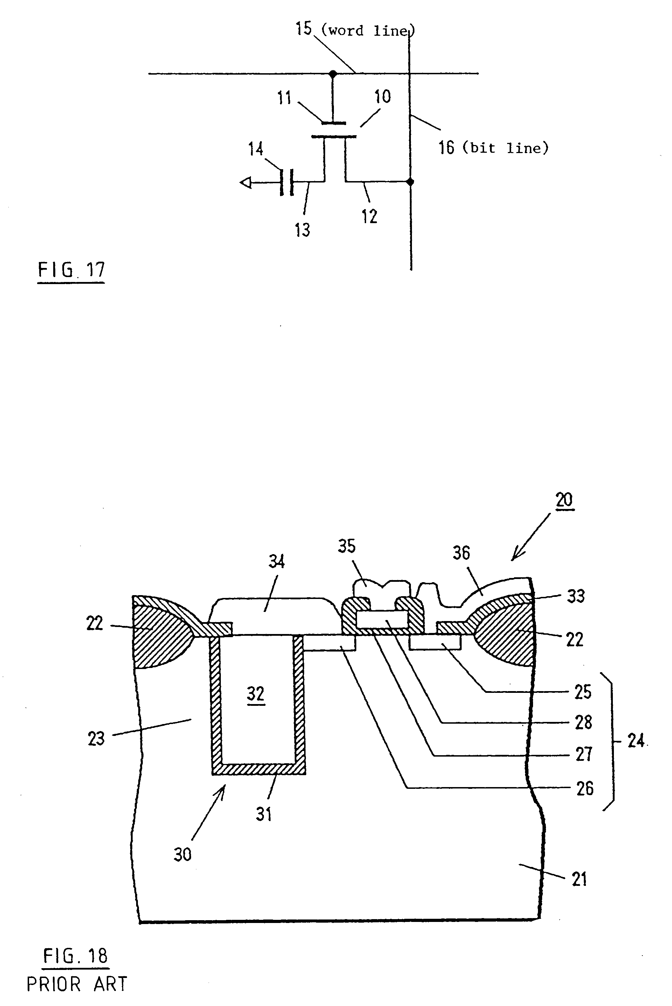

Conventionally, various types of dynamic semiconductor memory cells have been proposed which consist of one MOSFET and one trench-type capacitor. Figure 17 is a circuit diagram showing a commonly used dynamic semiconductor memory cell. In Figure 17, a MOSFET 10 has electrodes of a gate 11, a drain 12 and a source 13. A memory capacitor 14 is connected between the source 13 and a substrate potential. A word line 15 and a bit line 16 are connected to the gate 11 and the drain 12, respectively.

In the above circuit, when, in the read operation, the MOSFET 10 is turned on by applying an energing voltage to the word line 15, a voltage variation appears at the bit line 16 depending on the existence of stored charges in the memory capacitor 14. By associating the presence/absence of the stored charge with binary information, the read operation is performed based on the voltage variation at the bit line 16.

For example, the following semiconductor memory cell structure has been proposed. Figure 18 is a partial sectional view showing part of a conventional structure of the semiconductor memory cell circuit of Figure 17. A plurality of semiconductor memory cells 20 are formed, for instance, on a p-type silicon substrate 21. Although not shown in the figure, a plurality of semiconductor memory cells 20 are arranged in array on the silicon substrate 21. Each semiconductor memory cell 20 is separated by oxide separation regions 22, and has a memory capacitor 23 and a single MOSFET 24. The MOSFET 24 consists of a drain region 25 and a source region 26 that are n-type regions formed by diffusing n-type impurities into the p-type silicon substrate 21, and a gate electrode 28 made of polysilicon formed on a gate oxide film 27. On the other hand, the memory capacitor 23 is formed on the surface of a trench 30 that is formed in the p-type silicon substrate 21 in the vicinity of the source region 26. That is, the memory capacitor 23 is formed by employing the p-type silicon substrate 21 as one electrode and the embedded polysilicon region 32 as the other electrode, and insulating these two electrodes by an insulating film 31 such as a silicon dioxide film. The source region 26 is connected to the embedded polysilicon region 32 via an aluminum layer 34. Aluminum layers 35 and 36 are a word line and a bit line and connected to the gate electrode 28 and the drain region 25 via contact holes provided in the insulating film 33, respectively.

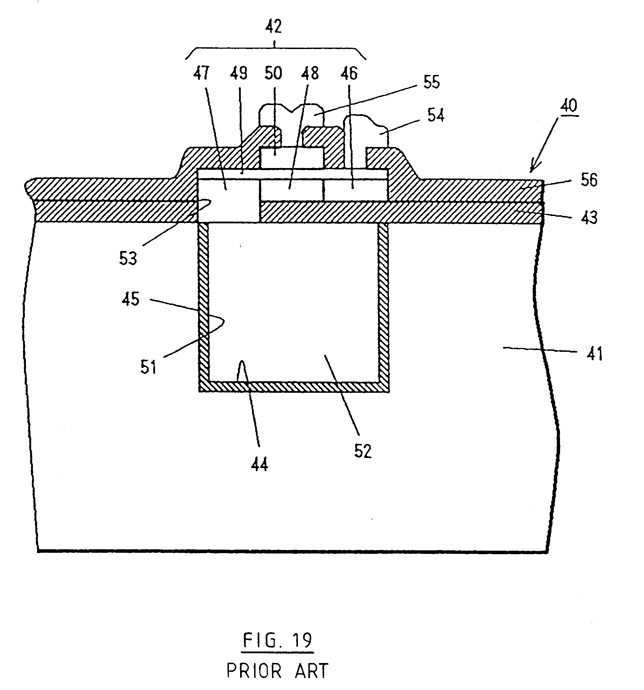

Figure 19 shows a semiconductor memory cell 40 having a structure described in Published Unexamined Patent Application No. 2-81471. 41 represents a p-type silicon substrate. A MOSFET 42 is formed on the silicon substrate 41 via an insulating film 43. A trench 44 having approximately the same cross-sectional shape as the bottom face of the MOSFET 42 is provided in the silicon substrate 41 just under the MOSFET 42, to constitute a memory capacitor 45. The MOSFET 42 consists of a drain region 46 and a source region 47 that are formed by diffusing n-type impurities into a polysilicon film formed on the insulating film 43, and a gate electrode 50 made of polysilicon formed on a gate oxide film 49.

On the other hand, the memory capacitor 45 consists of a nitride film 51 formed on the inner wall of the trench 44 and a polysilicon layer 52. A contact hole 53 is provided in the insulating film 43, to connect the source region 47 and the polysilicon layer 52. A bit line 54 and a word line 55 in the form of an aluminum layer are connected to the drain region 46 and the gate electrode 50 via contact holes provided in the insulating film 56, respectively.

PUPA No. 62-98766 describes a structure of a semiconductor memory cell consisting of a trench-type capacitor and a MOSFET using an epitaxial layer. However, since the epitaxial layer is thicker than a single-crystallized film of the SOI structure, a larger leak current is likely to occur at a reversely biased pn junction. That is, the charge stored in the trench-type capacitor is likely to leak to a p⁺-type silicon substrate via the pn junction.

In the case of the structure of Figure 18, a depletion layer is formed between the source region 26 and the p-type silicon substrate 21 when the pn junction is reversely biased. An alpha ray entering the depletion layer generates an electron-hole pair, thereby causing a leak current. The leak current at the reversely biased state will reduce the stored charge in the memory capacitor 23, thereby shortening the storage time. Therefore, it is necessary to set the storage time at an unduly long one. Furthermore, it is important to increase the capacity of the memory capacitor 23.

In the case of the structure of Figure 19, since no pn junction is formed between the source region 47 and the p-type silicon substrate 41, the storage time is not shortened due to the leak current at the pn junction. However, since all of the p-type region 48 just under the gate electrode 50, the drain region 46 and the source region 47 are made of polysilicon, this type of MOSFET will fail to provide good electrical characteristics when compared with MOSFETs using a single crystal.

Further, since the MOSFET 42 is provided just over the trench 44 via the insulating film 43 by conducting mask positioning, highly accurate mask positioning is first required when the contact hole 53 for the connection to the memory capacitor 45 is formed in the insulating film 43, specifically when the opening area of the trench 44 is small. Highly accurate mask positioning is also required when the source region 47 is formed on the contact hole 53. Thus, this structure needs highly accurate mask positioning in its manufacture. In addition, since this structure requires that the insulating film 43 be formed on the memory capacitor 45 to insulate the MOSFET 42 from the memory capacitor 45, its manufacturing process should include steps for forming the insulating film 43 and making a contact hole.

Accordingly, the invention provides a semiconductor memory cell comprising a semiconductor substrate; a trench provided in a surface of said substrate; an insulating coating provided on the substrate surface and on the surface of the trench; embedded charge storage means provided on the insulating coating on the trench surface so as to fill the trench to substantially the same level as the insulating coating on the substrate surface; a semiconductor layer provided on the insulating coating on the substrate surface and on the embedded charge storage means, having two spaced apart impurity regions of the same conduction type, one of said two impurity regions being entirely located on the insulating coating on the substrate surface; a control electrode located between said two impurity regions and separated from the semiconductor layer by an insulating layer; an insulating film covering the insulating coating on the substrate surface, the embedded charge storage means, the semiconductor layer and the control electrode; and a conductive layer connected to the impurity region located on the insulating coating on the substrate surface via an opening in the insulating film.

In a preferred embodiment the semiconductor memory cell further comprises:
a second trench provided in the surface of the substrate close to the first trench, the insulating coating being also provided on the surface of the second trench;
and embedded charge storage means provided on the insulating coating on the surface of the second trench so as to fill said second trench to substantially the same level as the first trench;
wherein said semiconductor layer is provided on the insulating coating on the substrate surface between the two trenches and on the embedded charge storage means in each of the two trenches, and has three spaced apart impurity regions of the same conduction type arranged such that a central one of the three impurity regions is entirely located on the insulating coating on said substrate surface between said pair of trenches, with control electrodes located between the central impurity region and each of the two impurity regions and separated from the semiconductor layer by an insulating layer, and said insulating film covers the insulating coating on the substrate surface, the embedded charge storage means, the semiconductor layer and the control electrodes, said conductive layer being connected to the central impurity region via an opening in the insulating film.

Such semiconductor memory cells typically comprise a MOS (metal-oxide-semiconductor) FET (field-effect transistor) and a trench-type capacitor produced by SOI (semiconductor on insulator) technology in which a device is formed in a semiconductor region provided on an insulator. Such a semiconductor memory cell has a structure which can prevent the leak current originating from the pn junction, and which can be manufactured easily and does not need highly accurate mask positioning in its manufacture. A MOSFET having good electrical characteristics may easily be formed using the SOI technology. The storage time is elongated by combining the MOSFET thus formed and a trench-type memory capacitor.

The invention also provides a semiconductor memory cell comprising a semiconductor substrate; a pair of trenches provided close to each other in the surface of the substrate; an insulating coating provided on the surface of each of the trenches; embedded charge storage means provided on the insulating coating on the surface of each of the trenches so as to fill the trench to substantially the same level as the substrate surface; a semiconductor layer provided on the substrate surface between the pair of trenches and on the embedded charge storage means in each of the trenches, insulated from the substrate surface by an insulating layer formed by ion implantation, and having three impurity regions of the same conduction type, a central one of the three impurity regions being entirely located on the insulating layer formed on the substrate surface between the pair of trenches; a pair of control electrodes respectively located between the central impurity region and each of the other two impurity regions, and separated from the semiconductor layer by an insulating layer; an insulating film covering the semiconductor layer and the control electrodes; and a conductor layer connected to the central impurity region via an opening of said insulating film.

It is preferred that the semiconductor layer is a single crystal and the embedded charge storage means is a doped semiconductor.

The invention further provides a method of manufacturing a semiconductor memory cell, comprising the steps of:
preparing a semiconductor substrate;
forming a trench in a surface of said substrate;
forming an insulating coating on said trench surface and on said substrate surface;
filling said trench with a charge storage substance to substantially the same level as the insulating coating formed on the substrate surface;
forming a semiconductor layer on the insulating coating formed on the substrate surface and on the charge storage substance filling trench;
forming an insulating layer on said semiconductor layer;
forming a control electrode on said insulating layer formed on the semiconductor layer so that at least part of the control electrode covers the substrate surface in the vicinity of the trench;
forming two impurity regions of the same conduction type in the semiconductor layer using the control electrode as a mask;
forming an insulating film to cover the insulating coating formed on the substrate surface, the charge storage substance filling the trench, the semiconductor layer and the control electrode;
forming in the insulating film an opening to allow a connection to one of the two impurity regions; and
forming a conductive layer on the opening and the insulating film.

Preferably the method further comprises the steps of:
forming a second trench in the substrate close to the first;
forming an insulating coating on the surface of the second trench and on a surface of said substrate between the trenches;
filling the second trench with a charge storage substance to substantially the same level as the first trench;
forming a second control electrode on the insulating layer formed on the semiconductor layer so that at least part of each of two control electrodes covers the substrate surface between the pair of trenches;
forming a third impurity region of the same conduction type as the first two impurity regions in the semiconductor layer, using the control electrodes as a mask for forming the three impurity regions;
wherein said semiconductor layer is formed on the insulating coating formed on the substrate surface between the pair of trenches and on the charge storage substance filling each of the trenches; the insulating film covers the charge storage substance filling each of said trenches, and both of the control electrodes; and the opening in the insulating film provides a connection to a central one of the three impurity regions, which is located on the insulating layer formed on the substrate surface between the pair of trenches.

The invention also provides a method of manufacturing a semiconductor memory cell, comprising the steps of:
preparing a semiconductor substrate;
forming a pair of trenches close to each other in said substrate;
forming an insulating coating on the surface of each of the trenches and on a surface of the substrate;
filling each of said trenches wih a charge storage substance;
flattening the surface of the charge storage substance until the insulating layer on the substrate surface is removed;
forming a semiconductor layer on the substrate surface and on the surface of the charge storage substance in each of the trenches;
forming an insulating layer to insulate the semiconductor layer from the substrate surface by performing ion implantation from above the surface of said semiconductor layer, excluding at least part of the surface of the semiconductor layer that is located on the surface of the charge storage substance in each of the trenches;
forming an insulating layer on the semiconductor layer;
forming a pair of control electrodes on the insulating layer formed on said semiconductor layer so that at least part of each of the control electrodes covers the substrate surface between the pair of trenches;
forming three impurity regions of the same conduction type in the semiconductor layer using the control electrodes as a mask;
forming an insulating film to cover the semiconductor layer and the control electrodes;
forming in said insulating film an opening to provide a connection to the central impurity region of said three impurity regions;
forming a conductive layer on the opening and the insulating film.

Avantageously, the step of preparing the semiconductor substrate involves preparing a single crystal semiconductor substrate, and the step of forming said semiconductor layer comprises exposing a part of a surface of the single crystal semiconductor substrate by partially removing the insulating coating formed on the surface of the single crystal semiconductor substrate while leaving only a part of the insulating coating formed on the surface of the single crystal semiconductor substrate in the vicinity of the or each trench, forming a polycrystalline semiconductor layer on the remaining part of the insulating coating and on the charge storage substance filling said trench(es), and transforming the polycrystalline semiconductor layer into a single crystal using the exposed part of the surface of the single crystal semiconductor substrate as a seed.

Therefore a semiconductor memory cell may be formed in which a pair of trenches are provided close to each other in a surface of a semiconductor substrate, and an insulating layer or coating is provided on the substrate surface and on the surface of each of the trenches. An embedded charge storage means is provided on the insulating layer on each trench surface so as to fill the trench to substantially the same level as the insulating layer on the substrate surface. A semiconductor layer is provided on the insulating layer on the substrate surface between the pair of trenches and on the embedded charge storage means in each trench. The semiconductor layer has three impurity diffusion layers of the same conduction type arranged in a transverse direction apart from each other, in which the central impurity region of the three impurity regions is entirely located on the insulating layer on the substrate surface between the pair of trenches. A pair of control electrodes are provided respectively on the semiconductor layer between the central impurity region and the other two impurity regions via an insulating layer. An insulating film is provided to cover the insulating layer on the substrate surface, the embedded charge storage means, the semiconductor layer and the control electrodes, and has an opening for providing a connection to the central impurity region that is located on the insulating layer on the substrate surface between the pair of trenches. A conductor layer is connected to the central impurity region via the opening of the insulating film.

Another possible semiconductor memory cell has a trench provided in a surface of a semiconductor substrate, and an insulating layer provided on the substrate surface and on the surface of the trench. An embedded charge storage means is provided on the insulating layer on the trench surface so as to fill the trench to substantially the same level as the insulating layer on the substrate surface. A semiconductor layer is also provided on the insulating layer on the substrate surface and on the embedded charge storage means. The semiconductor layer has two impurity regions of the same conduction type arranged in a transverse direction apart from each other, in which one of the two impurity regions is entirely located on the insulating layer on the substrate surface. A control electrode is provided on the semiconductor layer between the two impurity regions via an insulating layer. An insulating film is provided to cover the insulating layer on the substrate surface, the embedded charge storage means, the semiconductor layer and the control electrode, and has an opening for providing a connection to the one impurity region that is located on the insulating layer on the substrate surface. A conductive layer is connected to the one impurity region via the opening of the insulating layer.

Another alternative is for a semiconductor memory cell in which a pair of trenches are provided close to each other in a surface of a semiconductor substrate, and an insulating layer is provided on the surface of each trench. An embedded charge storage means is provided on the insulating layer on each trench surface so as to fill the trench to substantially the same level as the substrate surface. A semiconductor layer is provided on the substrate surface between the pair of trenches and on the embedded charge storage means, insulated from the substrate surface by an insulating layer formed by ion implantation, and has three impurity regions of the same conduction type that are arranged in a transverse direction apart from each other, in which the central impurity region of the three impurity regions is entirely located on the insulating layer formed on the substrate surface between the pair of trenches. A pair of control electrodes are respectively provided on the semiconductor layer between the central impurity region and the other two impurity regions via an insulating layer. An insulating film is provided to cover the semiconductor layer and the control electrodes, and has an opening for providing a connection to the central impurity region that is located on the insulating layer formed on the substrate surface between the pair of trenches. A conductor layer is connected to the central impurity region via the opening.

Such a semiconductor memory cell may be manufactured by a process in which a pair of trenches are formed in a prepared semiconductor substrate close to each other, and an insulating layer or coating is formed on a surface of each trench and on a surface of the substrate. Then, each trench is filled with a charge storage substance to substantially the same level as the insulating layer formed on the substrate surface. Then, a semiconductor layer is formed on the insulating layer formed on the substrate surface between the pair of trenches and on the charge storage substance filling each of the trenches, and an insulating layer is formed on the semiconductor layer. Then, a pair of control electrodes are formed on the insulating layer formed on the semiconductor layer so that at least part of each control electrode covers the substrate surface between the pair of trenches. Subsequently, three impurity regions of the same conduction type are formed in the semiconductor layer using the control electrodes as a mask. Further, an insulating film is formed to cover the insulating layer formed on the substrate surface, the charge storage substance filling each trench, the semiconductor layer and the control electrodes. Finally, after an opening is formed in the insulating film to provide a connection to the central impurity region of the three impurity regions that is located on the insulating layer formed on the substrate surface between the pair of trenches, a conductive layer is formed on the opening and on the insulating film.

By employing an insulating film used for a trench-type memory capacitor also as an insulator for forming an SOI film, the manufacturing process for a semiconductor memory cell can be simplified.

In an alternative manufacturing method a trench is formed in a surface of a prepared semiconductor substrate, and an insulating layer is formed on the trench surface and on the substrate surface. Then, the trench is filled with a charge storage substance to substantially the same level as the insulating layer formed on the substrate surface. Then, a semiconductor layer is formed on the insulating layer formed on the substrate surface and on the charge storage substance filling the trench, and an insulating layer is formed on the semiconductor layer. Then, a control electrode is formed on the insulating layer formed on the semiconductor layer so that at least part of the control electrode covers the substrate surface in the vicinity of the trench. Subsequently, two impurity regions of the same conduction type are formed in the semiconductor layer using the control electrode as a mask. Further, an insulating film is formed to cover the insulating layer formed on the substrate surface, the charge storage substance filling the trench, the semiconductor layer and the control electrode. Finally, after an opening is formed in the insulating film to provide a connection to one of the two impurity regions that is located on the insulating layer formed on the substrate surface, a conductive layer is formed on the opening and insulating film.

In the above manufacturing methods of a semiconductor memory cell, it is preferred that a single crystal semiconductor substrate be prepared, and the semiconductor layer be formed by exposing a part of a surface of the single crystal semiconductor substrate by partially removing the insulating layer formed on the surface of the single crystal semiconductor substrate while leaving only a predetermined part of the insulating layer formed in the vicinity of the trench, forming a polycrystalline semiconductor layer on the remaining part of the insulating layer and on the charge storage substance filling the trench, and transforming the polycrystalline semiconductor layer into a single crystal using the exposed part of the surface of the single crystal semiconductor substrate as a seed.

In another alternative manufacturing method a semiconductor substrate is prepared, a pair of trenches are formed in a surface of the substrate close to each other, and an insulating layer is formed on a surface of each trench and on the substrate surface. Then, a charge storage substance is deposited on the insulating layer to fill each trench. Then, a surface of the charge storage substance is flattened until the insulating layer on the substrate surface is removed, and a semiconductor layer is formed on the substrate surface and on the surface of the charge storage substance in each trench. Then, an insulating layer is formed to insulate the semiconductor layer from the substrate surface by performing ion implantation from above a surface of the semiconductor layer except at least part of the surface of the semiconductor layer that is located on the surface of the charge storage substance in each trench, and thereafter performing a heat treatment. Then, an insulating layer is formed on the semiconductor layer. Then, a pair of control electrodes are formed on the insulating layer formed on the semiconductor layer so that at least part of each control electrode covers the substrate surface between the pair of trenches. Subsequently, three impurity regions of the same conduction type are formed in the semiconductor layer using the control electrodes as a mask. Further, an insulating film is formed to cover the semiconductor layer and the control electrodes. Next, after an opening is formed in the insulating film to provide a connection to a central impurity region of the three impurity regions that is located on the insulating layer formed on the substrate surface between the pair of trenches, a conductive layer is formed on the opening and the insulating film.

A detailed description will now be given of embodiments of the invention by way of example, with reference to the following drawings:
Figures 1 to 10 show steps in the manufacture of a semiconductor memory cell according to a first embodiment of the invention;
Figure 11 shows a partial sectional view of a semiconductor memory cell according to the first embodiment of the invention;
Figure 12 shows a plan view of the semiconductor memory cell of Figure 11;
Figures 13 to 15 show steps in the manufacture of a semiconductor memory cell according to a second embodiment of the invention;
Figure 16 shows a partial sectional view of a semiconductor memory cell according to the second embodiment of the invention;
Figure 17 shows a circuit diagram of a dynamic semiconductor memory cell;
Figure 18 shows a partial sectional view illustrating a conventional structure for the semiconductor memory cell of Figure 17; and
Figure 19 shows a partial sectional view illustrating an alternative conventional structure for the semiconductor memory cell of Figure 17.

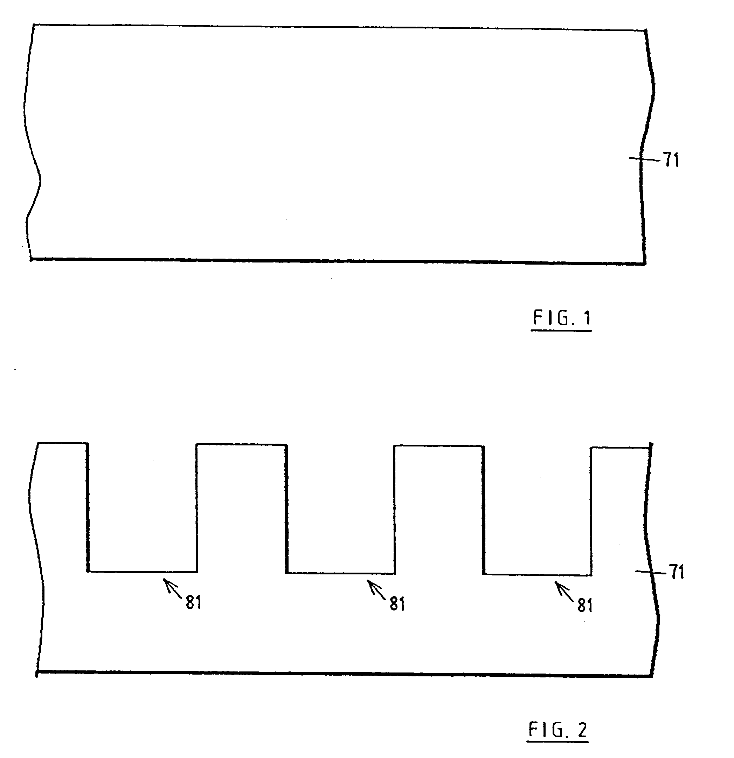

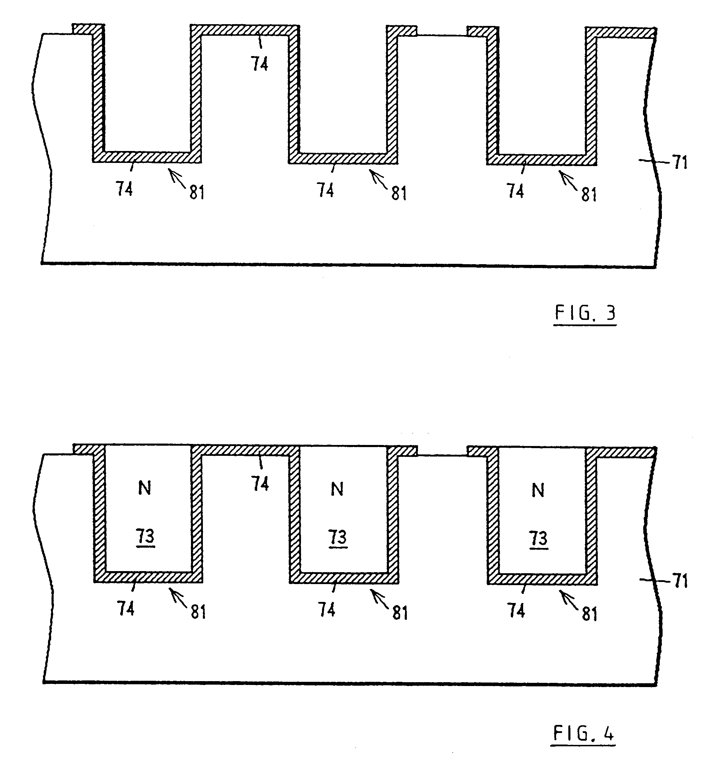

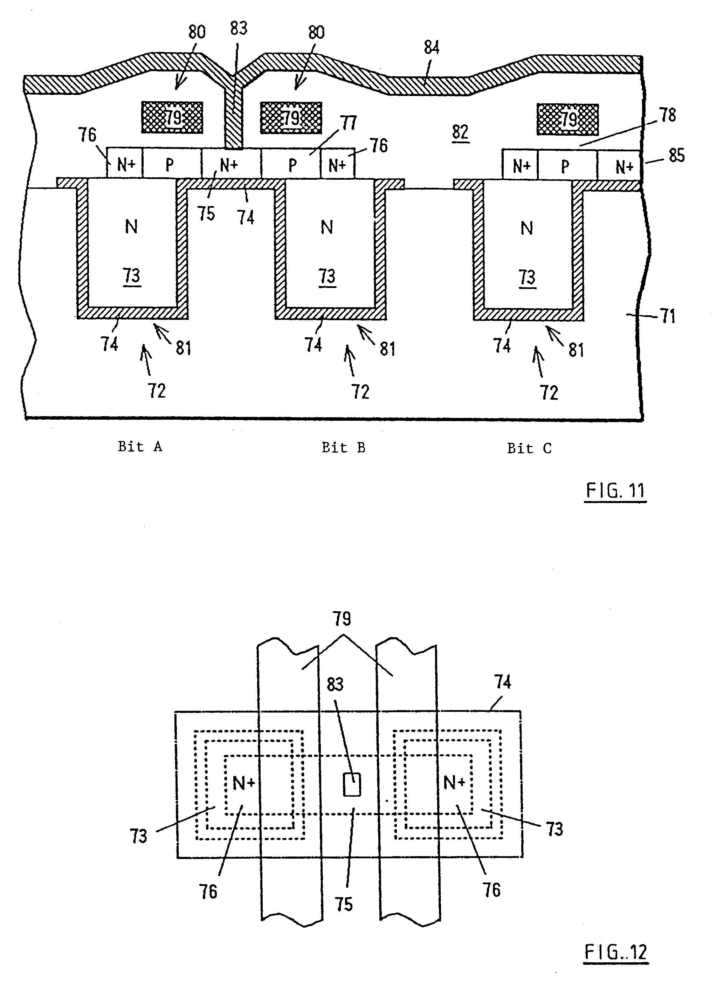

In Figure 11, a semiconductor memory cell 72 has a MOSFET 80 and a trench 81 for a memory capacitor that is formed in a p-type silicon substrate 71. First, the trench 81 is formed in the p-type silicon substrate 71 (see Figures 1 and 2). Then, an insulating film 74 is formed not only on the surface of the trench 81 but on the surface of the silicon substrate 71 (Figure 3), and the trench 81 is filled with polysilicon (a first polysilicon layer 73) (Figure 4). At this time the surface of the insulating film 74 formed on the p-type silicon substrate 71 (except for the trench portion) becomes approximately flush with that of the first polysilicon layer 73. That is, the surface of the silicon substrate 71 other than the trench portion is covered with the insulating film 74, and the surface of the insulating film 74 is exposed there. As shown in Figures 11 and 12, parts of the insulating film 74 in the vicinity of a pair of bits A and B are removed to expose the surface of the silicon substrate 71. This step is necessary to transform into a single crystal a polysilicon film on the insulating film 74 by using the exposed part of the silicon substrate 71 as a seed. The insulating film 74 is used as a dielectric material of the memory capacitor and as an SOI film, i.e., an insulating film on which a semiconductor region is to be formed. The insulating film 74 may be a silicon oxide film or a silicon nitride film, or a double layer film thereof.

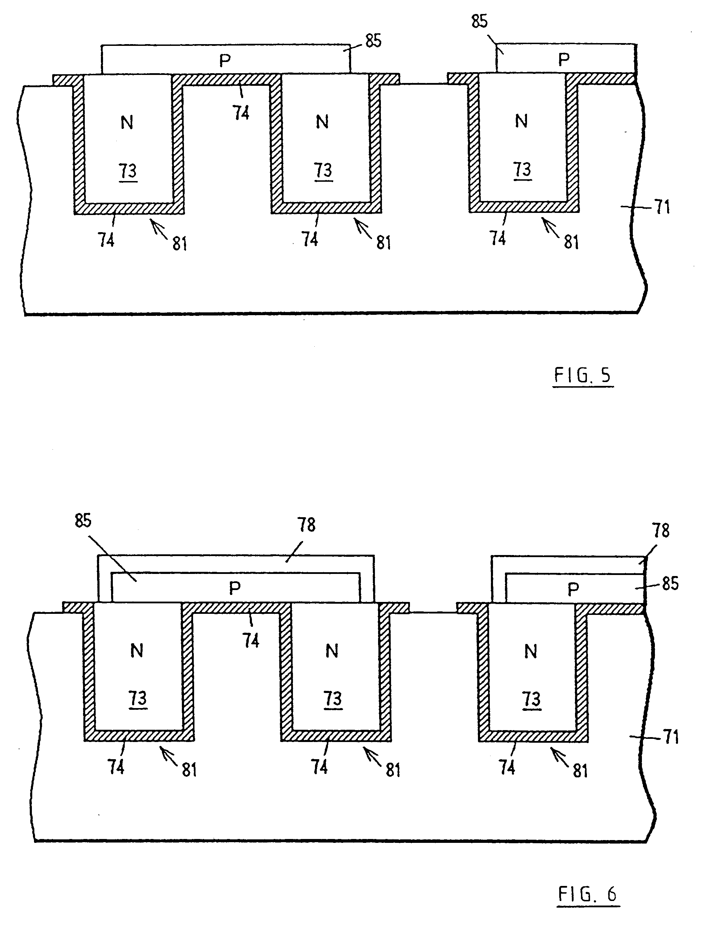

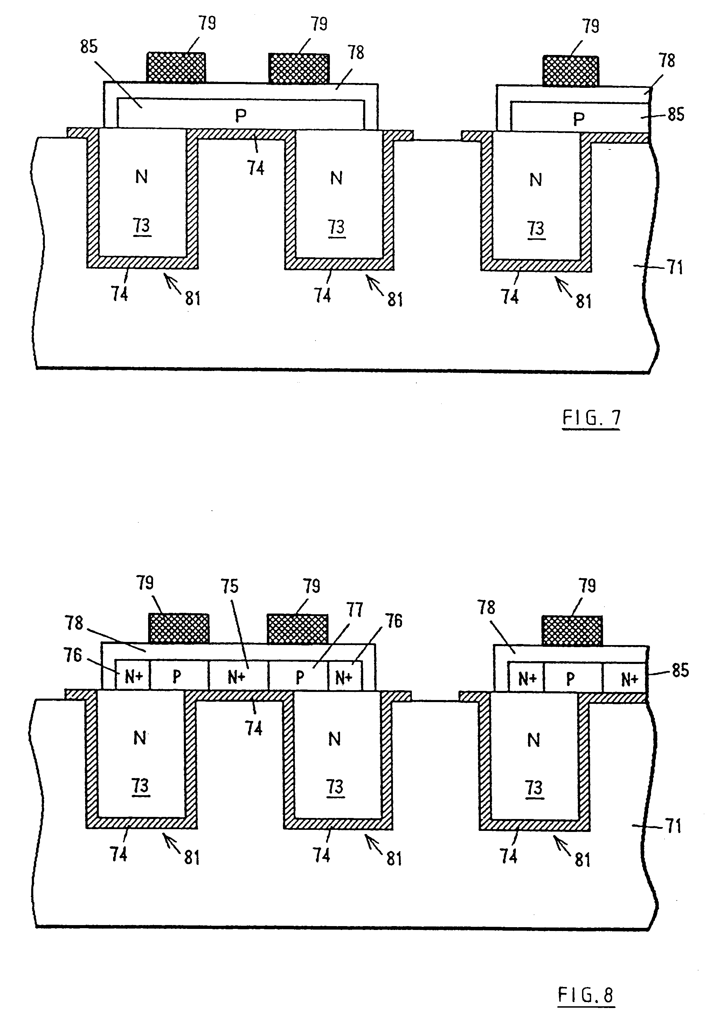

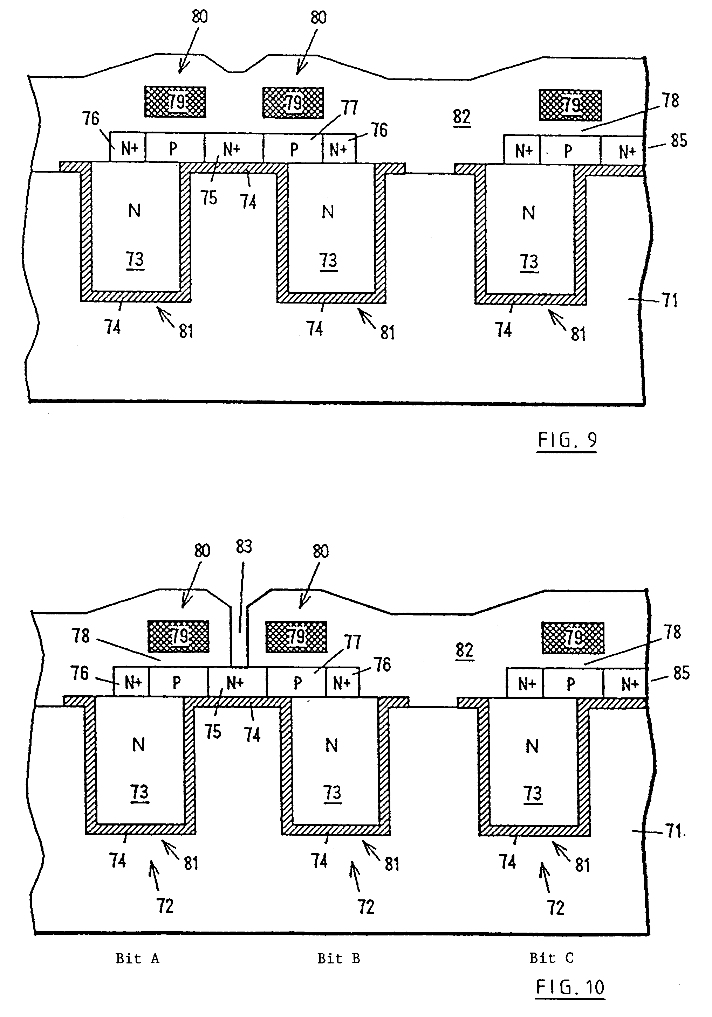

Then, a p-type second polysilicon film 85 is formed (Figure 5), and transformed into a single crystal by, for instance, illuminating it with a laser beam. As mentioned above, in this transformation into a single crystal, the neighboring exposed surface of the silicon substrate 71 is used as a seed. The unnecessary parts of the second polysilicon film 85 are thereafter removed. In this film removal step, as is understood from the plan view of Figure 12, it suffices that the mask positioning is performed so as to assure that the trench 81 is generally covered with the part of the second polysilicon film 85 that remains on the trench 81; that is, the mask positioning need not be performed with high accuracy. Then, the surface of the single-crystallized silicon layer 85 is oxidized to form a gate insulating film 78 (Figure 6). Next, a gate electrode 79 is formed using a third polysilicon film (Figure 7). As is understood from the plan view of Figure 12, in this gate electrode formation step, the gate electrode 79 may overlap with the trench 81 as long as the part of the surface of the silicon substrate 71 that is adjacent to the trench 81 is covered with at least part of the gate electrode 79, and, therefore, the mask positioning need not be performed with high accuracy either. Then, n⁺ regions 75 and 76 are formed by implanting, for instance, phosphorus ions (Figure 8). Then, an insulating film 82 is formed (Figure 9). Further, a via-hole 83 is formed (Figure 10) in the insulating film 82, and the n⁺ region 75 is connected to a bit line 84 via the via-hole 83 (Figure 11).

While in the embodiment described above with reference to Figures 1-12 the same film serves both as the insulating film 74 for the memory capacitor and as the insulating film 74 for the SOI, these insulating films may be formed in separate processes in the following manner. First, after the trench 81 is formed in the p-type silicon substrate 71 and the insulating film 74 is formed, the trench 81 is filled with polysilicon (polysilicon layer 73). Then, the polysilicon layer 73 and the insulating film 74 on the surface of the silicon substrate 71 are removed (flattened) to such an extent that the insulating film 74 deposited on the surface of the silicon substrate 71 except the part deposited in the trench 81 is just removed by grinding. Then, the surface of the silicon substrate 71 is oxidized for the SOI formation. According to this process, process parameters of the insulating film for the memory capacitor and that for the SOI can be optimized. However, since the surface of the polysilicon layer 73 is oxidized in this process, it is necessary to add a step of forming an opening for connecting the n⁺ region 76 of the MOSFET 80 to the polysilicon layer 73. Further, although Figures 1-12 show a structure in which the n⁺ region 75 is shared with the MOSFETs 80 of bits A and B to increase the degree of integration, two n⁺ regions 75 may be provided separately for the respective MOSFETs 80 of bits A and B.

This memory cell operates as follows. When the MOSFET 80 is selected upon application of a positive voltage to its gate electrode 79, the charge stored in the trench 81 is transferred to the bit line 84 via the MOSFET 80 in the read operation. In the write operation, charge is stored in the trench 81 via the MOSFET 80 upon application of a voltage to the bit line 84. Since the MOSFET 80 is isolated from the silicon substrate 71 as is understood from Figure 11, no leak current flows into or from the silicon substrate 71. Since the junction area of the pn junction formed on the insulating film 74 is extremely small, the leak current due to reverse biasing of the pn junction can be made small.

Further, since the MOSFET 80 is formed in the single-crystallized silicon layer 85, it can exhibit superior electrical characteristics. Since the transformation into a single crystal is performed using the neighboring exposed surface of the silicon substrate 71 as a seed, it can be performed easily and the resultant silicon layer 85 has high quality.

Figure 11 shows bits A, B and C. Advantageously, even if the interval between bits A and B is reduced, no leak current flows between bits A and B because the respective trenches 81 are covered with the insulating film 74. Similarly, no leak current flows between bits B and C.

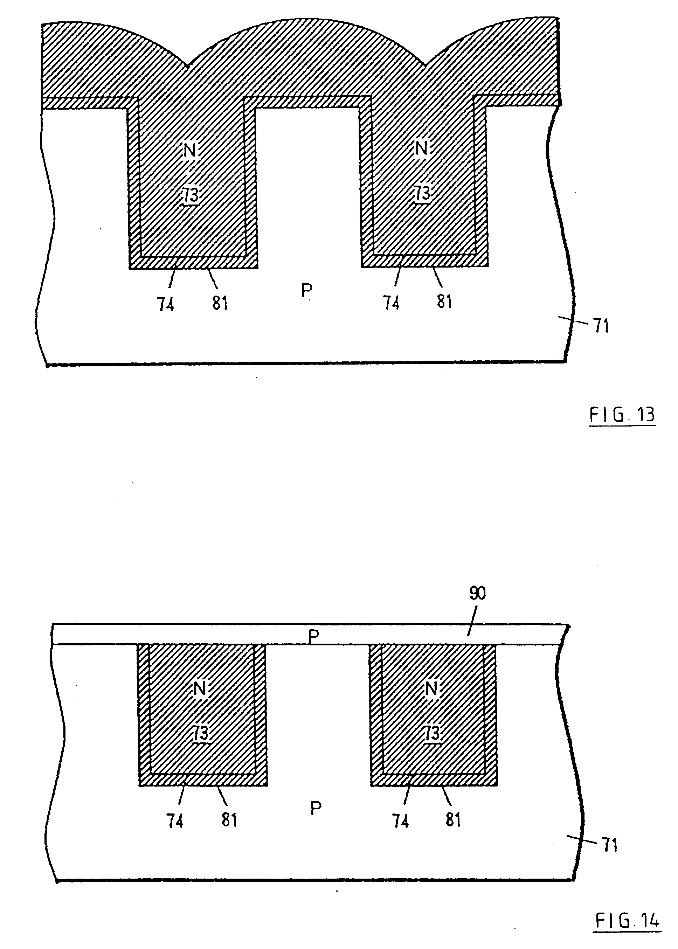

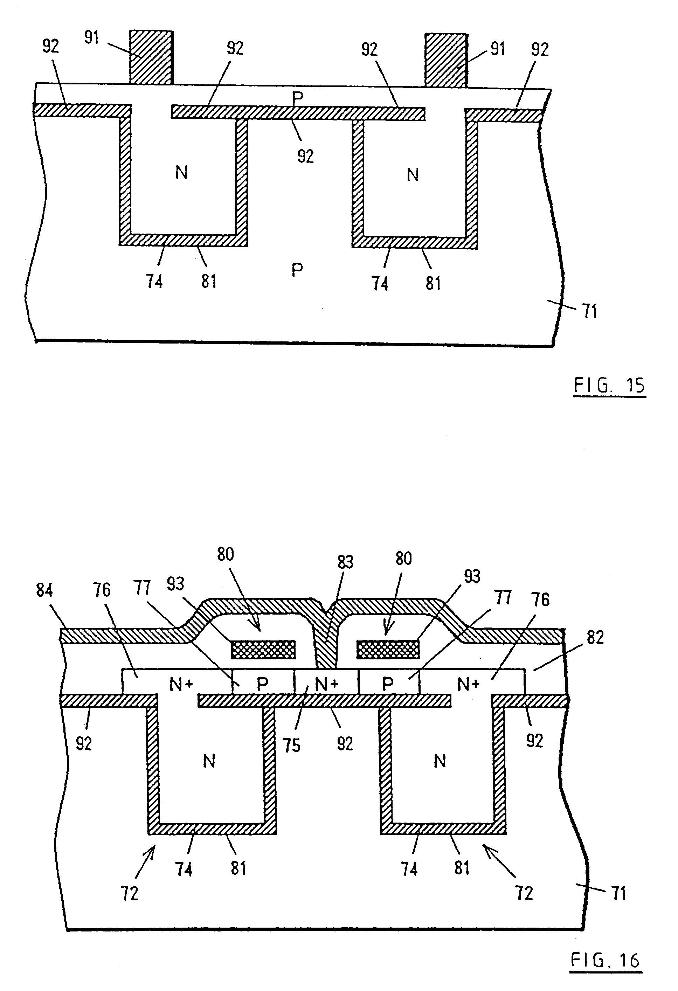

Figure 16 shows a structure of a semiconductor memory cell according to second embodiment of the invention. Figures 13-15 show a process for manufacturing the semiconductor memory cell of Figure 16. Referring to these figures, the semiconductor memory cell and the manufacturing method therefor according to the second embodiment are described below.

In Figure 16, a semiconductor memory cell 72 has a MOSFET 80 and a trench 81 for a memory capacitor that is formed in a p-type silicon substrate 71. The trench 81 is first formed in the p-type silicon substrate 71, and then an insulating film 74 is formed not only on the surface of the trench 81 but on the surface of the silicon substrate 71. Further, the trench 81 is filled with polysilicon (a first polysilicon layer 73 used as a charge storage means) (see Figure 13).

Next, the surface of the silicon substrate 71 is flattened by a chemimechanical grinding method to such an extent that the insulating film 74 formed on the silicon substrate 71 is just removed. Further, another p-type silicon film 90 is formed on this flat surface by epitaxial growth (Figure 14).

Then, oxygen ions are implanted using a mask of a photoresist pattern 91 formed on the silicon film 90 (Figure 15). Although care should be taken to assure that the part of the surface of the silicon substrate 71 between a pair of trenches 81 is not covered with the photoresist pattern 91, it suffices that at least part of the surface of the first polysilicon layer 73 embedded in the trench 81 is covered with the photoresist pattern 91. Therefore, the mask positioning to form the photoresist pattern 91 need not be performed with high accuracy as in the case of the first embodiment. Oxygen ions are implanted to an appropriate depth from the surface of the silicon film 90 (e.g., 250 nm) so as to reach the surface of the silicon substrate 71. Although not shown in any drawings, the photoresist pattern 91 is removed after completion of the oxygen ion implantation and then a thermal treatment is performed to form an insulating film 92 for the SOI (Figure 15).

Then, if desired, the unnecessary parts of the silicon film 90 are removed. In this removal step, highly accurate mask positioning is not required, because it suffices that the mask positioning be performed so as to assure that the trench 81 is generally covered with the silicon film 90 left on the trench 81. After an insulating layer is formed on the surface of the remaining silicon film 90, a gate electrode 93 is formed by a second polysilicon film. Then, n⁺ regions 75 and 76 are formed by implanting, for instance, phosphorus ions using the gate electrode 93 as a mask. Further, an insulating film 82 for covering the insulating layer 92, silicon film 90 and gate electrode 93 is formed. After a via-hole 83 is formed in the insulating film 82, the n⁺ region 75 is connected to a bit line 84 via the via-hole 83 (Figure 16).

The second embodiment of the invention as described above with reference to Figures 13-16 has the advantage that MOSFETs having much superior electrical characteristics can be realized, in addition to the advantages of the first embodiment of the invention. That is, since the epitaxially grown p-type silicon film 90 and the oxygen-ion-implanted SOI insulating layer 92 are employed, the silicon film 90 having superior crystal form can be used for the formation of the MOSFET.

As described above, the storage operation can be stabilized by virtue of the elongated storage time that is realized by the leak current reduction. Further, since the interval between the adjacent trenches can be shortened, a higher-density memory device can be obtained.

Since the insulating film 74 for the trench-type memory capacitor is also used for the formation of the SOI, a structure can be realized in the combination of the trench-type memory capacitor and the MOSFET that is formed using the SOI which does not require highly accurate mask positioning in forming the MOSFET, and which can increase the degree of integration.

Furthermore, since it is not necessary to separately form on a surface of the substrate an insulating film for insulating the MOSFET from the trench-type memory capacitor and make a contact hole, the manufacturing process is free from the steps of forming usch an insulating film and making a contact hole, which results in the reduction of manufacturing time and cost.

A specific case of constituting a 64-megabit-class memory is described here. In Figure 11, the dimensions in the X-direction of the n⁺ region 75, p region 77, n⁺ region 76, trench 81, and the interval between the trenches of bits A and B are set at 0.4 µm, 0.4 µm, 0.4 µm, 0.5 µm and 1.0 µm, respectively, in which case the area of the semiconductor memory cell becomes approximately 1.4 µm². With these dimensions, a sufficiently large allowance for the mask positioning is obtained, and the MOSFET 80 is formed so as to have a structure that can provide electrical characteristics good enough to assure that it can be put into actual use.

With regard to the process parameters, the impurity concentrations of the n⁺ regions 75 and 76, n region 73 and p region 77 are set at 1 × 10²⁰, 1 × 10²⁰, 1 × 10¹⁷ and 1 × 10¹⁷, respectively. Good results are obtained if the thickness of the silicon film on the insulating film 74 is set within the range of 50-2,000 nm. If the thickness of the n⁺ region 75 is kept constant, while the thickness of the p region 77 is increased the distance between the first polysilicon layer 73 and the n⁺ region 75 is increased equivalently in the overlapping area of the first polysilicon layer 73 and the p region 77, to provide a larger allowance for the mask positioning.

While the above example is described for the case of the minimum dimension 0.4 µm (grand rule), if the grand rule 0.25 µm is employed, the area of the semiconductor memory cell becomes about 0.5 µm² and it becomes possible to realize 256-megabit-class semiconductor memories.

## Claims

1. A semiconductor memory cell (72) comprising a semiconductor substrate (71); a trench (81) provided in a surface of said substrate; an insulating coating (74) provided on the substrate surface and on the surface of the trench; embedded charge storage means (73) provided on the insulating coating on the trench surface so as to fill the trench to substantially the same level as the insulating coating on the substrate surface; a semiconductor layer (85) provided on the insulating coating on the substrate surface and on the embedded charge storage means, having two spaced apart impurity regions (75, 76) of the same conduction type, one of said two impurity regions being entirely located on the insulating coating on the substrate surface; a control electrode (79) located between said two impurity regions and separated from the semiconductor layer by an insulating layer (78); an insulating film covering (82) the insulating coating on the substrate surface, the embedded charge storage means, the semiconductor layer and the control electrode; and a conductive layer (84) connected to the impurity region located on the insulating coating on the substrate surface via an opening (83) in the insulating film.

2. A semiconductor memory cell as claimed in claim 1, further comprising:
a second trench provided in the surface of the substrate close to the first trench, the insulating coating being also provided on the surface of the second trench;
and embedded charge storage means provided on the insulating coating on the surface of the second trench so as to fill said second trench to substantially the same level as the first trench;
wherein said semiconductor layer is provided on the insulating coating on the substrate surface between the two trenches and on the embedded charge storage means in each of the two trenches, and has three spaced apart impurity regions of the same conduction type arranged such that a central one of the three impurity regions is entirely located on the insulating coating on said substrate surface between said pair of trenches, with control electrodes located between the central impurity region and each of the two impurity regions and separated from the semiconductor layer by an insulating layer, and said insulating film covers the insulating coating on the substrate surface, the embedded charge storage means, the semiconductor layer and the control electrodes, said conductive layer being connected to the central impurity region via an opening in the insulating film.

3. A semiconductor memory cell comprising a semiconductor substrate; a pair of trenches provided close to each other in the surface of the substrate; an insulating coating provided on the surface of each of the trenches; embedded charge storage means provided on the insulating coating on the surface of each of the trenches so as to fill the trench to substantially the same level as the substrate surface; a semiconductor layer provided on the substrate surface between the pair of trenches and on the embedded charge storage means in each of the trenches, insulated from the substrate surface by an insulating layer formed by ion implantation, and having three impurity regions of the same conduction type, a central one of the three impurity regions being entirely located on the insulating layer formed on the substrate surface between the pair of trenches; a pair of control electrodes respectively located between the central impurity region and each of the other two impurity regions, and separated from the semiconductor layer by an insulating layer; an insulating film covering the semiconductor layer and the control electrodes; and a conductor layer connected to the central impurity region via an opening of said insulating film.

4. A semiconductor memory cell as claimed in any preceding claim, wherein said semiconductor layer is a single crystal.

5. A semiconductor memory cell as claimed in any preceding claim, wherein said embedded charge storage means is a doped semiconductor.

6. A method of manufacturing a semiconductor memory cell, comprising the steps of:
preparing a semiconductor substrate;
forming a trench in a surface of said substrate;
forming an insulating coating on said trench surface and on said substrate surface;
filling said trench with a charge storage substance to substantially the same level as the insulating coating formed on the substrate surface;
forming a semiconductor layer on the insulating coating formed on the substrate surface and on the charge storage substance filling trench;
forming an insulating layer on said semiconductor layer;
forming a control electrode on said insulating layer formed on the semiconductor layer so that at least part of the control electrode covers the substrate surface in the vicinity of the trench;
forming two impurity regions of the same conduction type in the semiconductor layer using the control electrode as a mask;
forming an insulating film to cover the insulating coating formed on the substrate surface, the charge storage substance filling the trench, the semiconductor layer and the control electrode;
forming in the insulating film an opening to allow a connection to one of the two impurity regions; and
forming a conductive layer on the opening and the insulating film.

7. The method of claim 6, further comprising the steps of:
forming a second trench in the substrate close to the first;
forming an insulating coating on the surface of the second trench and on a surface of said substrate between the trenches;
filling the second trench with a charge storage substance to substantially the same level as the first trench;
forming a second control electrode on the insulating layer formed on the semiconductor layer so that at least part of each of two control electrodes covers the substrate surface between the pair of trenches;
forming a third impurity region of the same conduction type as the first two impurity regions in the semiconductor layer, using the control electrodes as a mask for forming the three impurity regions;
wherein said semiconductor layer is formed on the insulating coating formed on the substrate surface between the pair of trenches and on the charge storage substance filling each of the trenches; the insulating film covers the charge storage substance filling each of said trenches, and both of the control electrodes; and the opening in the insulating film provides a connection to a central one of the three impurity regions, which is located on the insulating layer formed on the substrate surface between the pair of trenches.

8. A method of manufacturing a semiconductor memory cell, comprising the steps of:
preparing a semiconductor substrate;
forming a pair of trenches close to each other in said substrate;
forming an insulating coating on the surface of each of the trenches and on a surface of the substrate;
filling each of said trenches wih a charge storage substance;
flattening the surface of the charge storage substance until the insulating layer on the substrate surface is removed;
forming a semiconductor layer on the substrate surface and on the surface of the charge storage substance in each of the trenches;
forming an insulating layer to insulate the semiconductor layer from the substrate surface by performing ion implantation from above the surface of said semiconductor layer, excluding at least part of the surface of the semiconductor layer that is located on the surface of the charge storage substance in each of the trenches;
forming an insulating layer on the semiconductor layer;
forming a pair of control electrodes on the insulating layer formed on said semiconductor layer so that at least part of each of the control electrodes covers the substrate surface between the pair of trenches;
forming three impurity regions of the same conduction type in the semiconductor layer using the control electrodes as a mask;
forming an insulating film to cover the semiconductor layer and the control electrodes;
forming in said insulating film an opening to provide a connection to the central impurity region of said three impurity regions;
forming a conductive layer on the opening and the insulating film.

9. The method of claim 6, 7 or 8, wherein the step of preparing the semiconductor substrate is preparing a single crystal semiconductor substrate, and wherein the step of forming said semiconductor layer comprises exposing a part of a surface of the single crystal semiconductor substrate by partially removing the insulating coating formed on the surface of the single crystal semiconductor substrate while leaving only a part of the insulating coating formed on the surface of the single crystal semiconductor substrate in the vicinity of the or each trench, forming a polycrystalline semiconductor layer on the remaining part of the insulating coating and on the charge storage substance filling said trench(es), and transforming the polycrystalline semiconductor layer into a single crystal using the exposed part of the surface of the single crystal semiconductor substrate as a seed.
